# EUROPÄISCHE PATENTSCHRIFT

(11) **EP 3 244 519 B1**
(45) Veröffentlichungstag und Bekanntmachung des Hinweises auf die Patenterteilung: **11.12.2019**
(21) Anmeldenummer: 17160432.5
(22) Anmeldetag: 10.03.2017
(51) Int. Cl.: H02M 1/12, H05K 7/20, H01F 27/02, H01F 27/08, H03H 7/01, H03H 1/00, H02K 7/14, H03H 7/54

(54) **FILTER**
FILTER
FILTRE

(30) Priorität: 13.05.2016 DE 202016102587 U
(43) Veröffentlichungstag der Anmeldung: 15.11.2017
(73) Patentinhaber: SCHAFFNER EMV AG, 4542 Luterbach (CH)
(72) Erfinder: Dalessandro, Luca, 8005 Zürich (CH); Wuethrich, Martin, 3324 Hindelbank (CH); Häberle, Norbert, 4514 Lommiswil (CH)
(74) Vertreter: P&TS SA (AG, Ltd.)

(56) Entgegenhaltungen:
- CA-A1- 2 498 993
- US-A1- 2010 156 194
- US-A1- 2015 351 278
- US-A1- 2015 380 147

## Beschreibung

### Technisches Gebiet

Die Erfindung bezieht sich auf einen Filter, insbesondere die konstruktive Anordnung der Filterelemente in dessen Gehäuse.

### Stand der Technik

Filter in dreiphasigen Stromnetzen mit einer Spule in jeder stromführenden Phase und einer Spule und einem Kondensator zwischen einem Verbindungspunkt jeder Phase und einem Sternpunkt sind allgemein bekannt. Optional weisen solche Filter eine dritte Spule nach dem Verbindungspunkt auf. Die Induktivität der ersten, zweiten und dritten Spule nimmt in dieser Reihenfolge ab, so dass auch die räumliche Ausdehnung eines ersten Spulenblocks aus den ersten Spulen grösser als die eines zweiten Spulenblocks aus den zweiten Spulen ist. Falls es einen dritten Spulenblock aus den dritten Spulen gibt, ist die räumliche Ausdehnung des zweiten Spulenblocks grösser als die des dritten Spulenblocks. Es ist ebenfalls bekannt, dass die Spulen bei grösseren Strömen sich stark erhitzen und eine aktive Kühlung zum Beispiel durch einen Ventilator benötigen, um die Verlustwärme zu begrenzen. Ein weiteres Problem dieser Filter ist der grosse Platzbedarf und das grosse Gewicht der Spulenblöcke und der Kondensatoren. Dies erschwert zum Beispiel die Montage eines solchen Filters an einer vertikalen Wand.

In US2015/0380147 wird ein LCL Filter beschrieben, der in einem auf Rollen angeordneten Gehäuse angeordnet ist. Der grössere Spulenblock ist hier bodenseitig angeordnet, während der Ventilator auf der gegenüberliegenden Seite des grösseren Spulenblocks angeordnet ist.

In US2015/351278 wird ein LCL Filter offenbart, dessen grösster Spulenblock zwischen Ventilator und dem kleineren Spulenblock angeordnet ist.

### Darstellung der Erfindung

Es ist Aufgabe der Erfindung, einen Filter zu konstruieren, der die Probleme des Stands der Technik behebt.

Die Aufgabe ist durch den erfindungsgemässen Filter nach Anspruch 1 gelöst.

Überraschenderweise hat sich ergeben, dass die Anordnung des räumlich grössten Spulenblocks vor dem Ventilator die Verlustwärme am effektivsten reduziert, obwohl der kleinere Spulenblocks oder die kleineren Spulenblöcke so im Windschatten des grösseren Spulenblocks angeordnet ist/sind und somit kaum gekühlt wird/werden. Da der grösste Spulenblock den grössten Beitrag zur Verlustwärme beiträgt, scheint es effektiver zu sein, nur den grössten Spulenblock mit maximaler Kühlleistung zu kühlen, als alle drei Spulenblöcke mit einer mittleren Kühlleistung zu kühlen. Durch die Anordnung des grösseren Spulenblocks bei dem Ventilator ist auch die Luftgeschwindigkeit an dem grösseren Spulenblock grösser als bei dem kleineren Spulenblock und somit die Kühlung effektiver. Die Verjüngung des Gehäuses von der ersten Seite zu der zweiten Seite hin erlaubt den Gesamtplatzbedarf des Gehäuses zu verringern, da grosse Spulenblöcke an der ersten Seite und kleine Spulenblöcke an der zweiten Seite angeordnet werden können. Somit ist die Gehäusegrösse nur im Bereich des grössten Spulenblocks maximal und kann sich zu den kleineren Spulen hin verkleinern. Wenn sich der Luftstrom von der ersten Seite des Gehäuses zu dessen zweiten Seite bewegt, so ergibt sich eine Art Kamineffekt, der eine besonders laminare Strömung in dem Gehäuse erzeugt und somit einen besseren Wärmeabtransport schafft. Gleichzeitig wird der Luftstrom hinter dem ersten Spulenblock wieder zurück zu dem/den kleineren zweiten Spulenblock und evtl. dritten Spulenblock geführt. Somit schafft die Verjüngung, dass die kleinere(n) zweite und evtl. dritte Spule hinter der ersten Spule besser gekühlt werden. Dieser Effekt wird weiter verstärkt, wenn der Filter eine Montageseite aufweist, die Befestigungsmittel aufweist, um den Filter an einer vertikalen Wand so aufzuhängen, dass die zweite Seite zum Boden gerichtet ist. Vorzugsweise wird die Verjüngung des Gehäuses durch eine Schräge Gehäusewandung/-seite erreicht, vorzugsweise einer gegenüber der Montageseite des Filters angeordneten Seite. Letzteres hat den Vorteil, dass der Schwerpunkt des Filters näher an die Wand rückt als es bei einem rechteckigen Gehäuse der Fall wäre, insbesondere wenn auf der sich verjüngenden gegenüber der Montageseite angeordnete Gehäusewandung weitere Bauteile wie z.B. die Kondensatoren und/oder ein dritter Spulenblock montiert ist. Dadurch werden die auf die Wandaufhängung wirkenden Kräfte reduziert.

Die abhängigen Ansprüche betreffen weitere vorteilhafte Ausführungsbeispiele.

In einem Ausführungsbeispiel sind drei Spulenblöcke in einer Linie zwischen der ersten Seite des Gehäuses und der zweiten Seite des Gehäuses der Grösse nach absteigend angeordnet sind. Dies ist insbesondere im Zusammenhang mit dem sich verjüngenden Gehäuse vorteilhaft, da der dritte Spulenblock immer noch ausreichend gekühlt wird.

In einem Ausführungsbeispiel ist der dritte Spulenblock auf der Aussenseite einer Seite des Gehäuses, die gegenüber der Montageseite des Filters liegt, angeordnet. Dadurch kann das Gehäuse verkürzt werden. Vorzugsweise wird der dritte oder drittgrösste Spulenblock über dem zweiten oder zweitgrössten Spulenblock angeordnet und eine Ausnehmung in der den dritten Spulenblock tragenden Seite des Gehäuses vorgesehen, um zumindest einen Teil des Luftstroms des Ventilators aus dem Gehäuse zu dem dritten Spulenblock zu leiten.

In einem Ausführungsbeispiel wird der Filter an einer vertikalen Wand befestigt, so dass die erste Seite nach unten und die zweite Seite des Gehäuses nach oben gerichtet sind. Dies verbessert den Wärmeabtransport, da die Wärme aufsteigt und somit sich in die gleiche Richtung des Luftstroms des Ventilators bewegt. Die Wandmontage hat zusätzlich den Vorteil, dass unter dem Filter genügend Abstand zum Boden besteht und der Ventilator auf der unteren Seite des Filters genügend Luft einsaugen kann.

### Kurze Beschreibung der Figuren

Die Erfindung wird anhand der beigefügten Figuren näher erläutert, wobei zeigen
- **Fig. 1**: einen Schaltplan eines Ausführungsbeispiels des Filters.
- **Fig. 1A**: eine erste alternative Schaltung für die zweiten Spulen und die Kondensatoren;
- **Fig. 1b**: eine zweite alternative Schaltung für die zweiten Spulen und die Kondensatoren;
- **Fig. 1C**: eine dritte alternative Schaltung für die zweiten Spulen und die Kondensatoren;
- **Fig. 2**: einen Schnitt durch ein erstes Ausführungsbeispiel des Filters.
- **Fig. 3**: eine erste dreidimensionale Ansicht des ersten Ausführungsbeispiels des Filters.
- **Fig. 4**: eine zweite dreidimensionale Ansicht des ersten Ausführungsbeispiels des Filters.
- **Fig. 5**: einen Schnitt durch ein zweites Ausführungsbeispiel des Filters.
- **Fig. 6**: eine erste dreidimensionale Ansicht des zweiten Ausführungsbeispiels des Filters.
- **Fig. 7**: eine zweite dreidimensionale Ansicht des zweiten Ausführungsbeispiels des Filters.

### Wege zur Ausführung der Erfindung

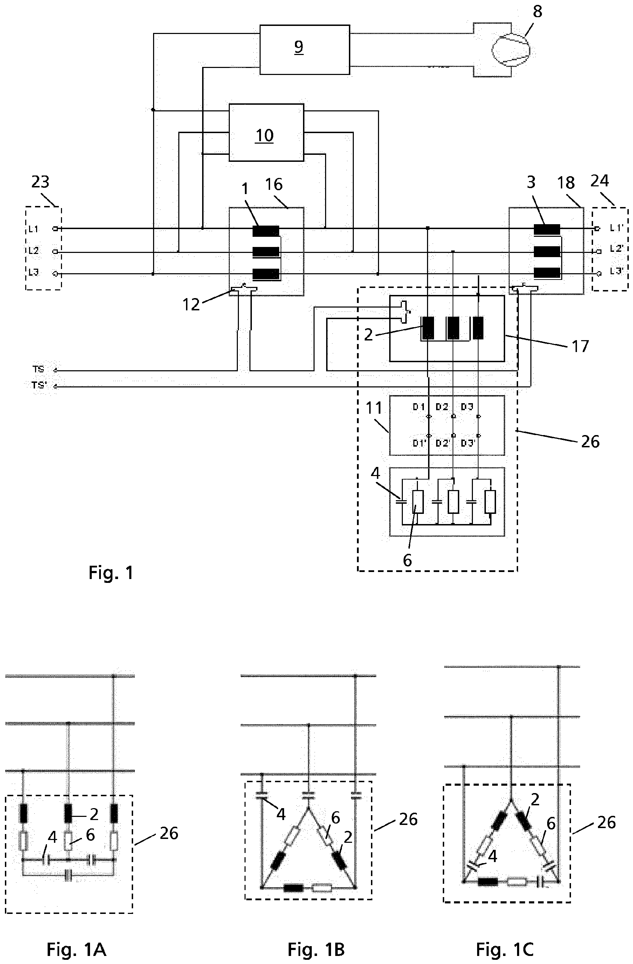

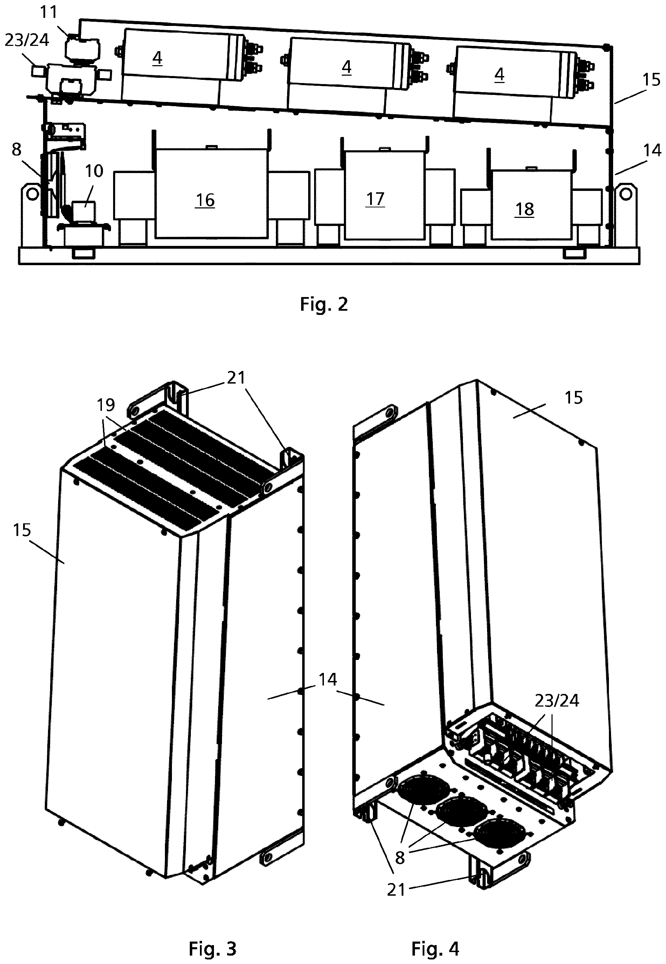

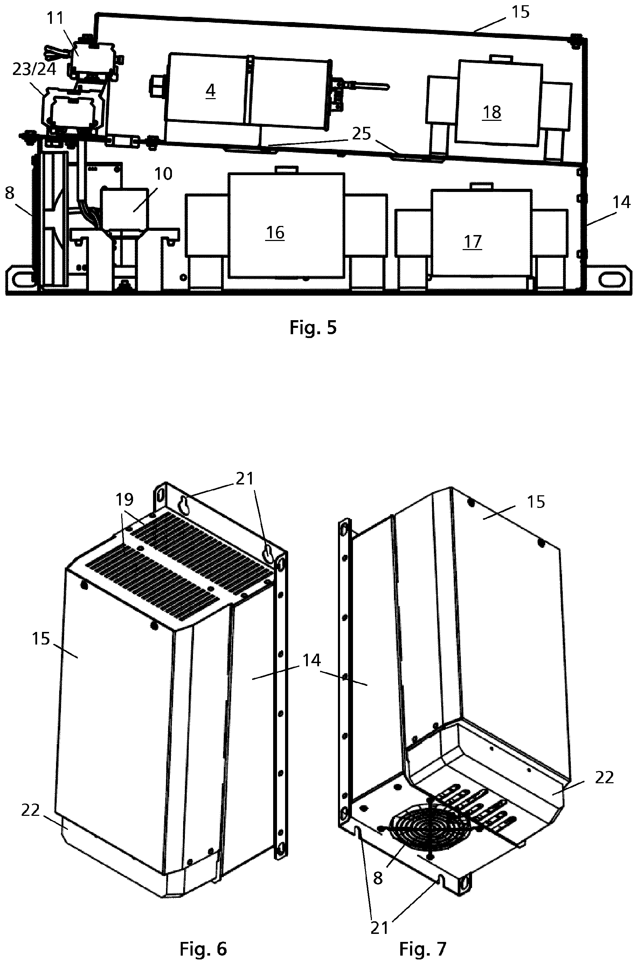

Fig. 1 zeigt ein Ausführungsbeispiel der elektrischen Schaltung des Filters, der als dreiphasiger Filter ausgebildet ist. Fig. 2 bis 4 zeigt ein erstes Ausführungsbeispiel der Konstruktion eines Filters. Fig. 5 bis 7 zeigt ein zweites Ausführungsbeispiel der Konstruktion eines Filters. Vorzugsweise handelt es sich hier um Filter für Leistungsbereiche grösser als 1 kW (Kilowatt).

Der Filter weist drei Eingangsterminals, drei Ausgangsterminals, einen ersten Spulenblock 16, einen zweiten Spulenblock 17, drei Kondensatoren 4 und ein Gehäuse 14 auf. Optional kann der Filter weiter zumindest einen von einem Ventilator 8, einem dritten Spulenblock 18, drei Widerständen 6, einem Dämpfungsblock 10, einem Leistungsblock 9 für den Ventilator 8 und einem Schaltmodul 11.

Der erste Spulenblock 16 weist drei erste Spulen 1 auf, eine für jede Phase L1, L2 und L3 in einem dreiphasigen Stromnetz. Der zweite Spulenblock 17 weist drei zweite Spulen 2 auf, eine für jede der Phasen L1, L2 und L3. Der optionale dritte Spulenblock 18 weist drei dritte Spulen 3 auf, eine für jede der Phasen L1, L2 und L3. Vorzugsweise sind die drei Spulen 1, 2 oder 3 der Spulenblöcke 16, 17 und/oder 18 über einen gemeinsamen Kern induktiv verbunden. Vorzugsweise haben die drei Spulen eines Spulenblocks die gleichen Induktivitäten. Optional kann einer oder können mehrere der Spulenblöcke 16, 17 oder 18 eine Hilfswicklung 12 aufweisen, um zu grosse Ströme, Kurzschlüsse oder Kühlstörungen zu detektieren. Diese Störstrommessungen können an zwei Terminals TS und TS' abgegriffen werden.

Die drei Eingangsterminals 23 sind elektrisch über drei elektrische Leiter mit den drei entsprechenden Ausgangsterminals 24 verbunden. Dabei entspricht jeder Eingangsterminal 23, jeder elektrischer Leiter und jeder Ausgangsterminal einer der drei Phasen L1, L2, L3, so dass pro Phase einer der drei Eingangsterminals 23 über einen der drei elektrischen Leiter mit einem der drei Ausgangsterminals 24 elektrisch verbunden ist. Die drei Eingangsterminals 23 werden vorzugsweise mit einem Dreiphasennetz verbunden. Die drei Ausgangsterminals 24 werden vorzugsweise mit einem dreiphasigen Verbraucher verbunden. Zwischen dem Dreiphasennetz und/oder dem dreiphasigen Verbraucher und dem Filter können aber auch Stromrichter, weitere Filter oder andere Geräte geschaltet sein. Verbraucher sind in der Regel Elektromotoren ohne auf solche beschränkt zu sein. Die Eingangs- und Ausgangsterminals 23 und 24 sind wie in den Figuren 2 und 4 gezeigt als Kabelklemmen ausgebildet. Allerdings ist es auch möglich, dass der Filter mit einem weiteren verbraucherseitigen Gerät eine Einheit bildet und der Ausgangsterminal 24 nur die imaginäre Grenze in einer elektrischen Leitung zwischen dem weiteren verbraucherseitigen Gerät und dem Filter darstellt. Allerdings ist es auch möglich, dass der Filter mit einem weiteren netzseitigen Gerät eine Einheit bildet und der Eingangsterminal 23 nur die imaginäre Grenze in einer elektrischen Leitung zwischen dem weiteren netzseitigen Gerät und dem Filter darstellt.

Jeder elektrischer Leiter weist zwischen dem Eingangsterminal 23 und einem Verbindungspunkt die erste Spule 1 des ersten Spulenblocks 16 auf. Die Verbindungspunkte der drei Phasen L1, L2, L3 sind über die drei zweiten Spulen 2 und die drei Kondensatoren 4 über die Schaltung 26 in Stern- und/oder Deltaschaltung verbunden. Fig. 1, 1A, 1B und 1C zeigen vier mögliche Schaltungen 26. Weitere Schaltungen der Kondensatoren 4 und der zweiten Spulen 2 sind möglich. Die zweite Spule 2 weist dabei eine kleinere Induktivität als die erste Spule 1 (in der gleichen Phase) auf. Jeder Verbindungspunkt einer der drei Phasen L1, L2, L3 ist elektrisch mit dem Ausgangsterminal 24 der entsprechenden Phase L1, L2, L3 verbunden.

In Fig. 1 verbinden die drei zweiten Spulen 2 und die drei Kondensatoren 4 beide die drei Verbindungspunkte sternförmig in der Schaltung 26. Jeder Verbindungspunkt der drei Phasen L1, L2, L3 ist elektrisch mit einem gemeinsamen Sternpunkt verbunden, wobei zwischen dem Verbindungspunkt und dem Sternpunkt für jede Phase die zweite Spule 2 des zweiten Spulenblocks 17 und einer der drei Kondensatoren 4 geschaltet ist. Vorzugsweise ist die zweite Spule 2 dabei auf der Seite des Verbindungspunkts und der Kondensator 4 auf der Seite des Sternpunkts angeordnet.

In Fig. 1A sind die drei Verbindungspunkte mit den drei zweiten Spulen 2 sternförmig und mit den drei Kondensatoren 4 deltaförmig verbunden. Jeder Verbindungspunkt der drei Phasen L1, L2, L3 ist hier elektrisch mit einem weiteren Verbindungspunkt der entsprechenden Phase verbunden, wobei zwischen dem Verbindungspunkt und weiteren Schaltpunkt für jede Phase die zweite Spule 2 des zweiten Spulenblocks 17 geschaltet ist. Die drei Kondensatoren 4 sind hingegen zwischen den drei weiteren Schaltpunkten deltaförmig geschaltet, d.h. ein Kondensator 4 zwischen je zwei weiteren Schaltpunkten.

In Fig. 1B sind die drei Verbindungspunkte mit den drei zweiten Spulen 2 deltaförmig und mit den drei Kondensatoren 4 sternförmig verbunden. Jeder Verbindungspunkt der drei Phasen L1, L2, L3 ist hier elektrisch mit einem weiteren Schaltpunkt der entsprechenden Phase verbunden, wobei zwischen dem Verbindungspunkt und weiteren Schaltpunkt für jede Phase ein Kondensator 4 geschaltet ist. Die drei zweiten Spulen des zweiten Spulenblocks 17 sind hingegen zwischen den drei weiteren Schaltpunkten deltaförmig geschaltet, d.h. eine zweite Spule 2 zwischen je zwei weiteren Schaltpunkten.

In Fig. 1C sind die drei Verbindungspunkte mit den drei zweiten Spulen 2 und mit den drei Kondensatoren 4 deltaförmig verbunden. Zwischen jedem Paar der drei Verbindungspunkte ist jeweils die zweite Spule 2 des zweiten Spulenblocks 17 und einer der drei Kondensatoren 4 geschalten.

Der Filter weist vorzugsweise weiter einen Ventilator 8 zur aktiven Kühlung des ersten Spulenblocks 16 und evtl. des zweiten Spulenblocks 17 und/oder des dritten Spulenblocks 18 auf. Vorzugsweise wird die notwendige Leistung für den Ventilator 8 direkt aus den stromführenden Phasen L1, L2, L3 entnommen. In dem gezeigten Modul wird der Ventilator 8 durch zwei der drei Phasen L1, L2, L3 versorgt. Vorzugsweise steuert ein Leistungsmodul 9 die notwendige Leistung für den Ventilator. Es wäre natürlich auch möglich, den Ventilator 8 mit einer anderen Stromquelle zu versorgen, z.B. eine externe Stromversorgung. Der Ventilator 8 kann auch aus mehreren Ventilatoreinheiten bestehen, wie dies in Fig. 4 gezeigt ist, um die Kühlleistung zu erhöhen. Vorzugsweise ist der Ventilator 8 so angeordnet, dass sich der Luftstrom von der ersten Seite des Gehäuses zu dessen zweiten Seite bewegt. Vorzugsweise ist der Ventilator 8 an der ersten Seite des Gehäuses angeordnet, um den Luftstrom in das Gehäuse zu drücken.

Optional kann der Filter durch den dritten Spulenblock 18 ergänzt werden, so dass zwischen dem Verbindungspunkt und dem Ausgangsterminal 24 jeder Phase die dritte Spule 3 des dritten Spulenblocks 18 geschaltet ist. Die dritte Spule 3 weist eine kleinere Induktivität als die zweite Spule 2 (in der gleichen Phase) auf.

Optional kann die Schaltung 26 weiterhin drei Widerstände 6 aufweisen. In der Fig. 1 wird zu jedem der drei Kondensatoren 4 einer der drei Widerstände 6 parallel geschaltet. In den Fig. 1A bis 1C wird jede zweite Spule 2 in Serie mit einem der drei Widerstände 6 geschaltet. Allerdings sind auch andere Schaltungen der Spulen möglich. Die Widerstände 6 ermöglichen eine Entladung der Kondensatoren 4 nach dem Ausschalten des Gerätes.

Optional kann der Filter einen Dämpfungsblock 10 aufweisen. Der Dämpfungsblock 10 sieht für jede Phase L1, L2, L3 zwischen dem Eingangsterminal 23 und dem Verbindungspunkt parallel zu der ersten Spule 1 ein RC Glied (Serienschaltung von Widerstand und Kondensator oder umgekehrt) vor. Dieses dient der effektiven Dämpfung von Oberschwingungen, welche durch den Schwingkreis aus der ersten Spule1, der zweiten Spule 2 und dem Kondensator 4 in einer Phase erzeugt werden. Details für den Dämpfungsblock 10 sind in US8115571 offenbart und sind hier per Referenz eingefügt.

Optional kann der Filter ein Schaltmodul 11 aufweisen. Das Schaltmodul 11 ist zwischen dem zweiten Spulenblock 17 und den drei Kondensatoren 4 geschalten. Vorzugsweise erlaubt das Schaltmodul 11 für jede Phase die Verbindung zwischen der zweiten Spule 2 und dem Kondensator 4 der gleichen Phase zu trennen. Dieses Schaltmodul kann zum Beispiel durch sechs Anschlussterminals ausgebildet sein, wobei jeweils zwei Anschlussterminals einer Phase mit einem Kabel verbunden sind. Der Benutzer kann nun die Kondensatoren 4 durch entfernen der Verbindungskabel trennen. Durch das Trennen/Ausschalten der Kondensatoren 4 lassen sich die Kondensatoren 4 für Situationen mit niedrigen Verbrauchsströmen ausschalten, um so kapazitive Ströme in dieser Verbrauchssituation zu eliminieren.

Das Gehäuse 14 ist zur Aufnahme des ersten Spulenblock 16 und des zweiten Spulenblocks 17 ausgebildet. Das Gehäuse 14 weist zumindest eine erste Seite und eine gegenüberliegende zweite Seite auf. An der ersten Seite ist der Ventilator 8 angeordnet, der durch eine Öffnung Umgebungsluft in das Gehäuse 14 leitet. Vorzugsweise weist die zweite Seite des Gehäuses 14 Öffnungen auf, um den Luftstrom des Ventilators 8 wieder aus dem Gehäuse 14 herauszuleiten. Somit bewegt sich der Luftstrom von der ersten Seite des Gehäuses 14 zu dessen zweiten Seite. Allerdings könnten die Öffnungen alternativ auch an anderen Seiten des Gehäuses 14 angeordnet sein. Der erste Spulenblock 16 und der zweite Spulenblock 17 sind nun in einer Linie zwischen der ersten und der zweiten Seite angeordnet, so dass der Luftstrom des Ventilators 8 die Wärme der ersten und zweiten Spulen 1 und 2 abtransportiert.

Eine Besonderheit dieses Filters ist es, dass der erste Spulenblock 16, der aufgrund der grössten Induktivität der ersten Spulen auch die grössten räumlichen Ausmasse hat, zwischen dem Ventilator 8 und dem kleineren zweiten Spulenblock 17 angeordnet ist. Dies erscheint zuerst unlogisch, da der kleinere Spulenblock 17 sich im Windschatten des grösseren Spulenblocks 16 befindet und somit nicht gekühlt wird. Trotzdem hat sich ergeben, dass die Gesamtverlustleistung mit dieser Anordnung im Vergleich zu einer Anordnung, in der die Spulenblöcke 16 und 17 vertauscht sind, signifikant reduziert wird. Dies liegt vermutlich daran, dass der grösste Spulenblock 16 auch der grösste Verlustwärmeverursacher ist und die optimale Kühlung dieses trotz der fehlenden Kühlung der anderen Spulenblöcke 17 und evtl. 18 zu einer reduzierten Verlustwärme führt.

Vorzugsweise ist die Form des Gehäuses 14 so angepasst, dass der zweite Spulenblock 17 trotz dieser Anordnung durch den Luftstrom gekühlt oder zumindest besser gekühlt wird. Dies wird durch ein Verjüngen des Gehäuses 14 von der ersten Seite in Richtung zu der zweiten Seite. Dies führt erstens zu einer Art Kamineffekt, der den Luftstrom in Richtung der zweiten Seite komprimiert und beschleunigt und somit die Kühlung des in Richtung der zweiten Seite angeordneten zweiten Spulenblocks 17 verbessert. Zweitens führt diese Verjüngung auch dazu, dass der Luftstrom des Ventilators 8 nach dem ersten Spulenblock 16 wieder zurück zu dem zweiten Spulenblock 17 geführt wird, so dass dieser besser gekühlt wird.

Vorzugsweise wird die Verjüngung des Gehäuses 14 dadurch erreicht, dass eine Seite unter einem Winkel (d.h. nicht parallel) zu der gegenüberliegenden Seite angeordnet ist. Vorzugsweise ist der Winkel vorzugsweise kleiner als 30°, vorzugsweise kleiner als 20°, vorzugsweise kleiner als 10°. Vorzugsweise ist der Winkel grösser als 0°, vorzugsweise grösser als 1°, vorzugsweise grösser als 2°, vorzugsweise grösser als 3°. Vorzugsweise ist die angewinkelte (vierte) Seite gegenüber der (dritten) Seite des Gehäuses 14, die zur Montage des Filters an einer Wand und/oder zur Befestigung des ersten Spulenblocks 16 und des zweiten Spulenblocks 17 ausgebildet ist. Vorzugsweise weist das Gehäuse 14 sechs Seitenflächen auf, wobei die erste Seite der zweiten Seite gegenüber angeordnet ist, die dritte Seite der vierten Seite gegenüber angeordnet ist und die fünfte Seite der sechsten Seite gegenüber angeordnet ist. Davon sind vorzugsweise fünf Seiten rechtwinkelig zueinander angeordnet, d.h. die erste, zweite, dritte, fünfte und sechste Seite. Die verbleibende (vierte) Seite unter dem genannten Winkel zu der gegenüberliegenden (dritten) Seite angeordnet ist. Allerdings können die anderen fünf Seiten auch anders als rechtwinkelig angeordnet werden. Es ist ebenfalls möglich, dass mindestens zwei Seiten nicht rechtwinkelig angeordnet sind und die mindestens zwei Seiten zur Verjüngung des Gehäuses 14 in Richtung der zweiten Seite beitragen.

Vorzugsweise wird der Filter so aufgehängt, dass die erste Seite des Gehäuses 14 in Bezug auf die Erdanziehung unten angeordnet ist und die zweite Seite des Gehäuses 14 oben. Dies unterstützt weiter eine optimale Kühlung, da der Luftstrom des Ventilators 8 in Richtung des natürlichen Wärmetransports ausgerichtet ist und somit ein besonders laminarer und effektiver Luftstrom zum Kühlen der Spulenblöcke 16, 17 und evtl. 18 erreicht werden kann. Dazu weist vorzugsweise die dritte Seite Aufhängemittel 21 auf, um den Filter an einer Wand zu befestigen.

Die drei Kondensatoren 4 hingegen, die keine aktive Kühlung benötigen werden ausserhalb des Gehäuses 14 auf einer der Ausseiten des Gehäuses 14 befestigt. Vorzugsweise ist dies die angewinkelte (vierte) Seite. Optional sind die Kondensatoren 4 von einer Gehäuseabdeckung 15 abgedeckt. Diese deckt vorzugsweise auch die (ganze) Seite des Gehäuses 14 ab, auf der die Kondensatoren 4 auf der Aussenseite montiert sind, z.B. auf der vierten Seite.

Auf der Seite des Gehäuses 14, z.B. der vierten Seite, auf der die Kondensatoren 4 befestigt sind, sind vorzugsweise auch die Eingangs- und Ausgangsterminals 23 und 24 befestigt. Vorzugsweise sind diese auf der Aussenseite des Gehäuses 14 befestigt. Vorzugsweise sind diese in Richtung der ersten Seite, d.h. bei aufgehängtem Filter unten, angeordnet, was die Zugänglichkeit vereinfacht.

Sollte das optionale Schaltmodul 11 enthalten sein, so ist dieses vorzugsweise über den Eingangs- und Ausgangsterminals 23 und 24 angeordnet, so dass dieses ebenfalls leicht bedienbar und zugänglich ist.

Die Eingangs- und Ausgangsterminals 23 und 24 und evtl. das optionale Schaltmodul 11 sind an einer Öffnung der Gehäuseabdeckung 15 angeordnet, wenn die optionale Gehäuseabdeckung 15 verwendet wird. In diesem Fall können die Eingangs- und Ausgangsterminals 23 und 24 und evtl. das optionale Schaltmodul 11 noch von einer weiteren Abdeckung 22 abgedeckt werden, so dass alle elektrisch leitendenden Elemente von dem Gehäuse 14 und den Abdeckungen 15 und 22 abgedeckt sind und von einem Benutzer im Betrieb nicht berührt werden können.

Sollte das optionale Dämpfungsmodul 10 enthalten sein, so ist dieses vorzugsweise in dem Gehäuse 14 angeordnet. Vorzugsweise ist dieses zwischen der ersten Seite und dem ersten Spulenblock 16 angeordnet.

In einem bevorzugten Ausführungsbeispiel ist ebenfalls der optionale dritte Spulenblock 18 enthalten. Je nach Grösse des Filters, gibt es nun verschiedene Ausführungsbeispiele.

In dem ersten Ausführungsbeispiel in Fig. 2 bis 4 ist der dritte Spulenblock 18 ebenfalls in dem Gehäuse 14 montiert. Der dritte Spulenblock 18 ist zusammen mit dem ersten Spulenblock 16 und dem zweiten Spulenblock 17 in einer Linie zwischen der ersten Seite und der zweiten Seite angeordnet. Da der dritte Spulenblock 18 ebenfalls kleiner als der zweite Spulenblock 17 ist und der zweite Spulenblock 17 zwischen dem ersten Spulenblock 16 und dem dritten Spulenblock 18 angeordnet ist, gilt für den dritten Spulenblock 18 in Bezug auf den zweiten Spulenblock 17 das gleiche analog wie für den zweiten Spulenblock 17 in Bezug auf den ersten Spulenblock 16 ausgeführt wurde. Zusammengefasst werden die in Richtung der zweiten Seite kleiner werdenden Spulenblöcke 16, 17, 18 trotz der Abdeckung durch den grössten Spulenblock 16 durch die sich verjüngende Form des Gehäuses 14 in Richtung der zweiten Seite effektiv gekühlt. In dieser Ausführungsform werden die drei Spulenblöcke in einer Linie in dem Gehäuse 14 angeordnet. Dies ist besonders für grosse Filter, d.h. Filter für grosse Leistungen, vorteilhaft, da deren Kondensatoren 4 so gross sind, dass die drei Kondensatoren 4 ebenfalls in einer Linie auf der vierten Seite in Richtung von der ersten Seite zu der zweiten Seite befestigt werden und/oder der dritte Spulenblock 18 bereits sehr schwer ist und sonst eine sehr massive Konstruktion des Gehäuses 14 bedarf. Die Kondensatoren 4 sind jeweils vorzugsweise als Kondensatorbank aus zwei oder drei oder mehr parallel geschalteten Kondensatoren gebildet. Vorzugsweise werden die parallel geschalteten Kondensatoren einer Kondensatorbank 4 rechtwinkelig in Richtung von der fünften zu der sechsten Seite angeordnet. Das erste Ausführungsbeispiel ist insbesondere für Leistungsbereiche grösser als 55 kW vorteilhaft.

In dem zweiten Ausführungsbeispiel in Fig. 5 bis 7 ist der dritte Spulenblock 18 zusammen mit den drei Kondensatoren 4 auf der Aussenseite einer Seite des Gehäuses 14, z.B. der vierten Seite, angeordnet. Die drei Kondensatoren 4 sind hier in Richtung von der fünften zu der sechsten Seite nacheinander aufgereiht. Optional können die drei Kondensatoren 4 und der dritte Spulenblock 18 von der Gehäuseabdeckung 15 abgedeckt werden. In diesem Fall sollte auch die Gehäuseabdeckung 15 auf der zweiten Seite Öffnungen für die Wärmeabluft aufweisen. Vorzugsweise weist die vierte Seite mindestens eine Öffnung 25 auf, um den Luftstrom des Ventilators 8 auch zu dem dritten Spulenblock 18 auf der Aussenseite des Gehäuses 14 zu leiten, um diesen zu kühlen. Vorzugsweise werden hierzu zwei Öffnungen 25, die beabstandet in einer Linie zwischen der ersten Seite und der zweiten Seite angeordnet sind, verwendet. Dies erzeugt einen laminareren Luftstrom, als wenn eine einzige grössere Öffnung in der vierten Seite angeordnet worden wäre. Vorzugsweise ist die erste Öffnung 25 unterhalb der Kondensatoren 4 auf der zu dem dritten Spulenblock 18 angeordneten Seite angeordnet, so dass die Kondensatoren 4 den Luftstrom in Richtung des dritten Spulenblocks 18 umlenken. Die zweite Öffnung 25 ist neben dem dritten Spulenblock 18 in Richtung zu den Kondensatoren 4 angeordnet. Das zweite Ausführungsbeispiel ist insbesondere für Leistungsbereiche kleiner als 55 kW vorteilhaft.

In den beschriebenen Ausführungsbeispielen ist die erste Spule 1 grösser als die zweite Spule 2. Allerdings sind auch Anwendungen möglich, in denen die zweite Spule 2 eine grössere Induktivität als die erste Spule 1 hat und der dann grössere zweite Spulenblock 17 zwischen dem Ventilator 8 und dem ersten Spulenblock 16 angeordnet wird.

Erfindungsgemäss werden die Spulenblöcke 16, 17, 18 der Grösse nach von dem Ventilator 8 aus aufgereiht, so dass der grösste Spulenblock am nächsten am Ventilator 8 angeordnet ist und der kleinste Spulenblock am weitesten entfernt ist. Die Grösse eines Spulenblocks ist durch die räumliche Grösse des Spulenblocks und/oder durch die Grösse der Induktivitäten der Spulen des Spulenblocks definiert. In der Regel ist der räumlich grösste Spulenblock auch der Spulenblock mit den Spulen mit den grössten Induktivitäten. Allerdings kann es auch Ausführungsbeispiele geben, in denen der räumlich grössere Spulenblock Spulen mit kleineren Induktivitäten oder gleich grossen Induktivitäten im Vergleich zu Spulen eines räumlich kleineren Spulenblocks. Da es sowohl Vorteile hat, den Spulenblock mit den grösseren Induktivitäten an dem Ventilator 8 anzuordnen, als auch den Spulenblock mit der grössten räumlichen Ausdehnung am Ventilator 8 anzuordnen, soll der grösste Spulenblock sowohl als Spulenblock mit den grössten Induktivitäten als auch als Spulenblock mit der grössten räumlichen Ausdehnung ausgelegt werden können.

Die räumliche Grösse eines Spulenblocks kann zum Beispiel durch sein Volumen oder seine Querschnittsfläche rechtwinkelig zu der Linie, in der die Spulenblöcke angeordnet sind. gemessen werden. Vorzugsweise wird aber die Querschnittsfläche rechtwinkelig zu der Linie, in der die Spulenblöcke angeordnet sind, als Mass für die räumliche Grösse verwendet.

Der Filter ist vorzugsweise ein elektromagnetischer Verträglichkeitsfilter (EMV Filter) und/oder ein Netzqualitätsfilter.

In dem zuvor beschriebenen Ausführungsbeispiel war die Induktivität L1 der ersten Spule 1 grösser als die Induktivität L2 der zweiten Spule 2, und die Induktivität L2 der zweiten Spule 2 grösser als die Induktivität L3 der dritten Spule 3. Es kann aber auch L2>L3>L1 oder L3>L2>L1 gelten. Es ist auch möglich, dass zwei oder drei der ersten Spule 1, der zweiten Spule 2 und der dritten Spule 3 die gleiche Induktivität haben. Vorzugsweise wird der Spulenblock mit den Spulen mit der grössten Induktivität zwischen dem Ventilator 8 und dem Spulenblock mit den Spulen mit der zweitgrössten Induktivität platziert, d.h. in den Fig. 2 und 4 wird der Spulenblock mit den Spulen mit der grössten Induktivität an die Stelle des Spulenblocks 16 und der Spulenblock mit den Spulen mit der zweitgrössten Induktivität anstelle des Spulenblocks 17 angeordnet. Der optionale Spulenblock mit den Spulen mit der drittgrössten Induktivität wird anstelle des Spulenblocks 18 angeordnet.

In dem zuvor beschriebenen Ausführungsbeispiel war räumliche Ausdehnung D1 des ersten Spulenblocks 16 grösser als die räumliche Ausdehnung D2 der zweiten Spule 2, und räumliche Ausdehnung D2 der zweiten Spule 2 grösser als die räumliche Ausdehnung D3 der dritten Spule 3. Es kann aber auch D2>D3>D1 oder D3>D2>D1 gelten. Es ist auch möglich, dass zwei oder drei der ersten Spule 1, der zweiten Spule 2 und der dritten Spule 3 die gleiche räumliche Ausdehnung haben. Vorzugsweise handelt es sich bei der räumliche Ausdehnung um die Ausdehnung rechtwinkelig zu der Linie zwischen der ersten und der zweiten Seite. Vorzugsweise wird der Spulenblock mit der grössten räumlichen Ausdehnung zwischen dem Ventilator 8 und dem Spulenblock mit der zweitgrössten räumlichen Ausdehnung platziert, d.h. in den Fig. 2 und 4 wird der Spulenblock mit der grössten räumlichen Ausdehnung an die Stelle des Spulenblocks 16 und der Spulenblock mit der zweitgrössten räumlichen Ausdehnung anstelle des Spulenblocks 17 angeordnet. Der optionale Spulenblock mit der drittgrössten räumlichen Ausdehnung wird anstelle des Spulenblocks 18 angeordnet.

In dem zuvor beschriebenen Ausführungsbeispiel wurden drei Spulen 1, 2 und 3 und deren drei Spulenblöcke 16, 17, 18 beschrieben. Allerdings kann der Filter auch nur zwei dieser drei Spulen 1, 2 und 3 in jeder Phase aufweisen bzw. nur zwei der drei Spulenblöcke 16, 17 und 18 aufweisen. Zuvor wurde bereits die dritte Spule 3 als optional beschrieben. Es ist aber auch ein Ausführungsbeispiel möglich, in dem die erste Spule 1 fehlt, und der Filter nur die zweite 2 und dritte Spule 3 aufweist, wie dies z.B. in einem Ausgangsfilter (output filter) der Fall ist. Es ist ebenfalls ein Ausführungsbeispiel denkbar, in dem die zweite Spule 2 fehlt, und der Filter nur die erste und dritte Spule 3 aufweist, wie dies z.B. in einem LCL Filter der Fall ist.

## Patentansprüche

1. Filter mit drei Phasen (L1, L2, L3) aufweisend für jede Phase (L1, L2, L3) einen Eingangsterminal (23), einen Ausgangsterminal (24) und einen Kondensator (4), wobei für jede der drei Phasen (L1, L2, L3) der Eingangsterminal (23) über einen Verbindungspunkt mit dem Ausgangsterminal (24) elektrisch verbunden ist, wobei die Verbindungspunkte der drei Phasen über die drei Kondensatoren (4) in Stern- und/oder Deltaform elektrisch verbunden sind, wobei der Filter ein Gehäuse (14), das zwei Spulenblöcke enthält, aufweist, wobei das Gehäuse (14) eine erste Seite und eine der ersten Seite gegenüberliegende zweite Seite aufweist, wobei die zwei Spulenblöcke entlang einer Linie zwischen der ersten Seite und der zweiten Seite angeordnet sind, wobei an der ersten Seite des Gehäuses (14) ein Ventilator (8) zur Kühlung der zwei Spulenblöcke angeordnet ist, wobei der grössere der zwei Spulenblöcke zwischen dem Ventilator (8) und dem kleineren der beiden Spulenblöcke angeordnet ist, wobei die zwei Spulenblöcke aus den folgenden drei Spulenblöcken ausgewählt sind:
ein erster Spulenblock (16) mit drei ersten Spulen (1), wobei für jede der drei Phasen (L1, L2, L3) eine der drei ersten Spulen (1) zwischen dem Verbindungspunkt und dem Eingangsterminal (23) geschaltet ist,
ein zweiter Spulenblock (17) mit drei zweiten Spulen (2), wobei die Verbindungspunkte der drei Phasen (L1, L2, L3) über die drei zweiten Spulen (2) und die drei Kondensatoren (4) in Stern- und/oder Deltaform elektrisch verbunden sind, und
ein dritter Spulenblock (18) mit drei dritten Spulen (3), wobei für jede der drei Phasen (L1, L2, L3) eine der drei dritten Spulen (3) zwischen dem Verbindungspunkt und dem Ausgangsterminal (24) geschaltet ist,
**dadurch gekennzeichnet, dass**
sich das Gehäuse (14) von der ersten Seite zu der zweiten Seite hin verjüngt.

2. Filter nach Anspruch 1, wobei das Gehäuse (14) eine dritte Seite zur Befestigung des Filters an einer Wand und/oder zur Befestigung des ersten Spulenblocks (16) und des zweiten Spulenblocks (17) und eine der dritten Seite gegenüberliegende vierte Seite aufweist, wobei der Abstand zwischen der dritten Seite und der vierten Seite in Richtung der zweiten Seite abnimmt.

3. Filter nach Anspruch 2, wobei das Gehäuse an der dritten Seite Aufhängemittel aufweist, um den Filter mit der dritten Seite an einer vertikalen Wand so zu befestigen, dass die erste Seite nach unten und/oder die zweite Seite nach oben weist.

4. Filter nach Anspruch 2 oder 3, wobei die drei Kondensatoren (4) an der Aussenseite der vierten Seite des Gehäuses (14) befestigt sind.

5. Filter nach einem der Ansprüche 2 bis 4, wobei der Filter die drei Spulenblöcke aufweist, wobei der drittgrösste der drei Spulenblöcke an der Aussenseite der vierten Seite des Gehäuses (14) befestigt ist.

6. Filter nach Anspruch 5, wobei der der kleinste der drei Spulenblöcke über dem zweitgrössten der drei Spulenblöcke angeordnet ist, und die Kondensatoren (4) über dem grössten der drei Spulenblöcke angeordnet ist.

7. Filter nach Anspruch 6, wobei die vierte Seite des Gehäuses eine Ausnehmung (25) zwischen den Kondensatoren (4) und dem drittgrössten der drei Spulenblöcke aufweist, der einen kühlenden Luftstrom des Ventilators (8) zu dem drittgrössten der drei Spulenblöcke leitet.

8. Filter nach einem der Ansprüche 2 bis 4, wobei der Filter die drei Spulenblöcke aufweist, wobei der drittgrösste der drei Spulenblöcke in dem Gehäuse (14) zwischen dem zweitgrössten Spulenblock und der zweiten Seite angeordnet ist.

9. Filter nach Anspruch 8, wobei die Kondensatoren (4) der drei Phasen (L1, L2, L3) an der Aussenseite der vierten Seite des Gehäuses (14) entlang der Linie zwischen der ersten Seite und der zweiten Seite des Gehäuses (14) angeordnet sind.

10. Filter nach einem der Ansprüche 2 bis 8 aufweisend eine Gehäuseabdeckung (15) zur Abdeckung der drei Kondensatoren (4) und/oder der vierten Seite des Gehäuses (14).

11. Filter nach Anspruch 10, wobei die Gehäuseabdeckung (15) in Richtung der ersten Seite des Gehäuses (14) einen Teil der vierten Seite frei lässt, auf dem die Eingangsterminals (23) und die Ausgangsterminals (24) angeordnet sind.

12. Filter nach einem der Ansprüche 1 bis 4, wobei die zwei ausgewählten Spulenblöcke der erste Spulenblock (16) und der zweite Spulenblock (17) sind.

13. Filter nach einem der Ansprüche 1 bis 12, wobei die räumliche Ausdehnung des grösseren Spulenblocks grösser als die räumliche Ausdehnung des kleineren Spulenblocks ist.

14. Filtersystem aufweisend eine vertikale Wand und einen Filter nach einem der vorigen Ansprüche, wobei das Gehäuse (14) eine dritte Seite aufweist, wobei das Gehäuse (14) mit der dritten Seite so an der Wand befestigt ist, dass die erste Seite des Gehäuses (14) nach unten und die zweite Seite des Gehäuses (14) nach oben gerichtet ist.

## Claims

1. Filter with three phases (L1, L2, L3) comprising for each phase an input terminal (23), an output terminal (24) and a capacitor (4), wherein for each of the three phases (L1, L2, L3) the input terminal (23) is electrically connected via a connection point to the output terminal (24), wherein the connection points of the three phases (L1, L2, L3) are electrically connected via the three capacitors (4) in star and/or delta form, wherein the filter comprises a housing (14) containing two coil blocks, wherein the housing (14) comprises a first side and a second side opposite the first side, wherein the two coil blocks are arranged along a line between the first side and the second side, wherein a fan (8) for cooling the two coil blocks is arranged on the first side of the housing (14), wherein the larger of the two coil blocks is arranged between the fan (8) and the smaller of the two coil blocks, wherein the two coil blocks are selected from the following three coil blocks:
a first coil block (16) having three first coils, wherein for each of the three phases (L1, L2, L3) one of the three first coils is connected between the connection point and the input terminal (23),
a second coil block (17) having three second coils, wherein the connection points of the three phases (L1, L2, L3) are electrically connected via the three second coils and the three capacitors (4) in star and/or delta form, and
a third coil block (18) having three third coils, wherein for each of the three phases (L1, L2, L3) one of the three third coils is connected between the connection point and the output terminal (24)
**characterized in that**
the housing (14) tapers from the first side towards the second side.

2. Filter according to claim 1, wherein the housing (14) comprises a third side for fixing the filter on a wall and/or for fixing the first coil block (16) and the second coil block (17) and a fourth side opposite the third side, wherein the distance between the third side and the fourth side decreases in the direction of the second side.

3. Filter according to claim 2, wherein the housing (14) comprises suspension means on the third side in order to fix the filter by the third side on a vertical wall such that the first side faces downwards and/or the second side faces upwards.

4. Filter according to claim 2 or 3, wherein the three capacitors (4) are fixed on the exterior of the fourth side of the housing (14).

5. Filter according to any of claims 2 to 4, wherein the filter comprises the three coil blocks, wherein the third largest of the three coil blocks is fixed on the exterior of the fourth side of the housing (14).

6. Filter according to claim 5, wherein the smallest of the three coil blocks is arranged above the second largest of the three coil blocks, and the capacitors (4) are arranged above the largest of the three coil blocks.

7. Filter according to claim 6, wherein the fourth side of the housing (14) comprises a cut-out (25) between the capacitors (4) and the third largest of the three coil blocks, which guides a cooling air flow of the fan (8) to the third largest of the three coil blocks.

8. Filter according to any of claims 2 to 4, wherein the filter comprises the three coil blocks, wherein the third largest of the three coil blocks is arranged in the housing (14) between the second largest coil block and the second side.

9. Filter according to claim 8, wherein the capacitors (4) of the three phases (L1, L2, L3) are arranged on the exterior of the fourth side of the housing (14) along the line between the first side and the second side of the housing (14).

10. Filter according to any of claims 2 to 9 comprising a housing (14) cover for covering the three capacitors (4) and/or the fourth side of the housing (14).

11. Filter according to claim 10, wherein the housing (14) cover, in the direction of the first side of the housing (14), leaves free a part of the fourth side on which the input terminals (23) and the output terminals (24) are arranged.

12. Filter according to any of claims 1 to 4, wherein the two selected coil blocks are the first coil block (16) and the second coil block (17).

13. Filter according to any of claims 1 to 12, wherein the spatial extent of the larger coil block is larger than the spatial extent of the smaller coil block.

14. Filter system comprising a vertical wall and a filter according to one of the previous claims, wherein the housing (14) comprises a third side, wherein the housing (14) is fixed with the third side on the wall such that the first side of the housing (14) is directed downwards and the second side of the housing (14) is directed upwards.

## Revendications

1. Filtre à trois phases (L1, L2, L3) comprenant, pour chaque phase (L1, L2, L3), une borne d'entrée (23), une borne de sortie (24) et un condensateur (4), pour chacune des trois phases (L1, L2, L3), la borne d'entrée (23) étant reliée électriquement à la borne de sortie (24) par le biais d'un point de liaison, les points de liaison des trois phases étant reliés électriquement en étoile et/ou en triangle par le biais de trois condensateurs (4), le filtre possédant un boîtier (14) qui contient deux blocs de bobines, le boîtier (14) possédant un premier côté et un deuxième côté à l'opposé du premier côté, les deux blocs de bobines étant disposés le long d'une ligne entre le premier côté et le deuxième côté, un ventilateur (8) destiné à refroidir les deux blocs de bobines étant disposé du premier côté du boîtier (14), le plus grand des deux blocs de bobines étant disposé entre le ventilateur (8) et le plus petit des deux blocs de bobines, les deux blocs de bobines étant choisis parmi les trois blocs de bobines suivants :
un premier bloc de bobines (16) comprenant trois premières bobines (1), pour chacune des trois phases (L1, L2, L3), l'une des trois premières bobines (1) étant connectée entre le point de liaison et la borne d'entrée (23),
un deuxième bloc de bobines (17) comprenant trois deuxièmes bobines (2), les points de liaison des trois phases (L1, L2, L3) étant reliés électriquement en étoile et/ou en triangle par le biais des trois deuxièmes bobines (2) et des trois condensateurs (4), et
un troisième bloc de bobines (18) comprenant trois troisièmes bobines (3), pour chacune des trois phases (L1, L2, L3), l'une des trois troisièmes bobines (3) étant connectée entre le point de liaison et la borne de sortie (24),
**caractérisé en ce que**
le boîtier (14) se rétrécit du premier côté est orienté vers le deuxième côté.

2. Filtre selon la revendication 1, avec lequel le boîtier (14) possède un troisième côté servant à la fixation du filtre à une paroi et/ou à la fixation du premier bloc de bobines (16) et du deuxième bloc de bobines (17) et un quatrième côté à l'opposé du troisième côté, l'écart entre le troisième côté et le quatrième côté diminuant en direction du deuxième côté.

3. Filtre selon la revendication 2, avec lequel le boîtier possède, sur le troisième côté, des moyens d'accrochage afin de fixer le filtre par le troisième côté à une paroi verticale de telle sorte que le premier côté est orienté vers le bas et/ou le deuxième côté vers le haut.

4. Filtre selon la revendication 2 ou 3, avec lequel les trois condensateurs (4) sont fixés au côté extérieur du quatrième côté du boîtier (14).

5. Filtre selon l'une des revendications 2 à 4, avec lequel le filtre possède les trois blocs de bobines, le troisième plus grand des trois blocs de bobines est fixé au côté extérieur du quatrième côté du boîtier (14).

6. Filtre selon la revendication 5, avec lequel le plus petit des trois blocs de bobines est disposé au-dessus du deuxième plus grand des trois blocs de bobines, et les condensateurs (4) sont disposés au-dessus du plus grand des trois blocs de bobines.

7. Filtre selon la revendication 6, avec lequel le quatrième côté du boîtier possède une cavité (25) entre les condensateurs (4) et le troisième plus grand des trois blocs de bobines, laquelle conduit un courant d'air de refroidissement du ventilateur (8) vers le troisième plus grand des trois blocs de bobines.

8. Filtre selon l'une des revendications 2 à 4, avec lequel le filtre possède les trois blocs de bobines, le troisième plus grand des trois blocs de bobines est disposé dans le boîtier (14) entre le deuxième plus grand bloc de bobines et le deuxième côté.

9. Filtre selon la revendication 8, avec lequel les condensateurs (4) des trois phases (L1, L2, L3) sont disposés sur le côté extérieur du quatrième côté du boîtier (14) le long de la ligne entre le premier côté et le deuxième côté du boîtier (14).

10. Filtre selon l'une des revendications 2 à 9, possédant un couvercle de boîtier (15) destiné à recouvrir les trois condensateurs (4) et/ou le quatrième côté du boîtier (14).

11. Filtre selon la revendication 10, avec lequel le couvercle de boîtier (15), dans la direction du premier côté du boîtier (14), laisse libre une partie du quatrième côté sur laquelle sont disposées la borne d'entrée (23) et la borne de sortie (24).

12. Filtre selon l'une des revendications 1 à 4, avec lequel les deux blocs de bobines choisis sont le premier bloc de bobines (16) et le deuxième bloc de bobines (17).

13. Filtre selon l'une des revendications 1 à 12, l'étendue dans l'espace du plus grand bloc de bobines étant supérieure à l'étendue dans l'espace du plus petit bloc de bobines.

14. Système de filtre possédant une paroi verticale et un filtre selon l'une des revendications précédentes, le boîtier (14) possédant un troisième côté, le boîtier (14) étant fixé à la paroi par le troisième côté de telle sorte que le premier côté du boîtier (14) soit orienté vers le bas et le deuxième côté du boîtier (14) soit orienté vers le haut.
